# EUROPÄISCHE PATENTANMELDUNG

(11) **EP 1 696 440 A1**
(43) Veröffentlichungstag der Anmeldung: **30.08.2006**
(21) Anmeldenummer: 06075407.4
(22) Anmeldetag: 21.02.2006
(51) Int. Cl.: G11C 11/22, H01L 27/115

(54) **Halbleiterspeichervorrichtung und Verfahren zur Herstellung einer Halbleiterspeichervorrichtung**

(30) Priorität: 24.02.2005 DE 102005009511
(71) Anmelder: Infineon Technologies AG, 81669 München (DE)
(72) Erfinder: Klauk, Hagen, Dr., 40195 Stutgart (DE); Halik, Marcus, Dr., 91058 Erlangen (DE); Schmid, Günther, Dr., 91334 Hemhofen (DE); Eder, Florian, 91052 Erlangen (DE)
(74) Vertreter: Gross, Felix

(57) **Zusammenfassung**

Die Erfindung betrifft eine Halbleiterspeichervorrichtung unter Verwendung mindestens einer ferroelektrischen Schicht, die mindestens ein elektrisch nicht leitendes Polymer und in dem Polymer verteilte ferroelektrische Nanopartikel aufweist. Die Erfindung betrifft darüber hinaus ein Verfahren zur Herstellung einer Halbleiterspeichervorrichtung unter Verwendung mindestens einer ferroelektrischen Schicht. Damit ist es möglich, eine Halbleiterspeichervorrichtung unter Verwendung mindestens einer ferroelektrischen Schicht auf preiswerten und gegebenenfalls flexiblen Substraten herzustellen.

## Beschreibung

Die Erfindung betrifft eine Halbleiterspeichervorrichtung nach dem Oberbegriff des Anspruchs 1 und ein Verfahren zum Herstellen einer Halbleiterspeichervorrichtung unter Verwendung ferroelektrischer Schichten nach dem Oberbegriff des Anspruchs 20.

Halbleiterspeichervorrichtungen können prinzipiell in flüchtige und nichtflüchtige Halbleiterspeichervorrichtungen unterteilt werden.

Der wichtigste und kommerziell erfolgreichste Vertreter der flüchtigen Halbleiterspeichervorrichtungen ist der DRAM ("dynamic random access memory"), bei dem die Informationen innerhalb der einzelnen Speicherzellen in der Form elektrischer Ladungen auf Kondensatoren gespeichert werden. Auf Grund unvermeidlicher Leckströme innerhalb der Speicherzellen und zwischen benachbarten Speicherzellen muss die auf den DRAM-Kondensatoren gespeicherte Ladung regelmäßig (meist mehrere Male je Sekunde) aufgefrischt werden; nach dem Abschalten der Betriebsspannung gehen die im DRAM gespeicherten Informationen generell verloren.

Dieser Nachteil wird bei nichtflüchtigen Halbleiterspeichervorrichtungen vermieden. Ein Beispiel für nichtflüchtige Halbleiterspeichervorrichtungen sind die ferroelektrischen Halbleiterspeichervorrichtungen, bei denen zur Informationsspeicherung das Phänomen der elektrischen Polarisierung ferroelektrischer Schichten genutzt wird. Ferroelektrische Materialien haben eine Kristallstruktur, die bei Unterschreiten einer bestimmten Temperatur (der Curie-Temperatur) aus energetischen Gründen vom vollständig symmetrischen kubischen Gitterzustand in einen nicht symmetrischen tetragonalen Gitterzustand übergeht. In diesem tetragonalen Gitter fallen die Schwerpunkte der positiven und der negativen Ladungen innerhalb der Einheitszelle nicht zusammen, und so entsteht in jeder Einheitszelle ein elektrischer Dipol. Innerhalb ferroelektrischer Kristallite beeinflussen sich die Dipole benachbarter Einheitszellen, so dass sich spontan Bereiche einheitlicher Dipolausrichtung (so genannte Domänen) bilden. Wird eine Schicht eines ferroelektrischen Materials zwischen zwei elektrisch leitfähigen Elektroden angeordnet, so kann die Schicht durch Anlegen einer positiven elektrischen Spannung in die eine Richtung und durch Anlegen einer negativen Spannung in die andere Richtung polarisiert werden. Die so eingestellte Orientierung der elektrischen Dipolmomente bleibt dank der internen Polarisation des ferroelektrischen Materials auch nach Abschalten der elektrischen Spannung erhalten.

Zum Auslesen der gespeicherten Information muss die Ausrichtung der internen Polarisation festgestellt werden. Dazu wird an die Schicht eine elektrische Spannung oberhalb der Koerzitiv-Spannung angelegt, so dass die Schicht in die eine oder andere Richtung polarisiert wird. Ist die Polarität der angelegten Spannung entgegengesetzt zur Richtung der internen Polarisation, so wird die Polarisation der Schicht umgekehrt, und die Verschiebung der elektrischen Ladungen innerhalb der Schicht führt zu einem kompensierenden Ladungsfluss im externen Stromkreis, der mittels einer geeigneten Verstärkerschaltung detektiert wird. Stimmt die Polarität der angelegten Spannung mit der Richtung der internen Polarisation überein, so kommt es nicht zu einer Umkehrung der Polarisation der Schicht und zu keinem kompensierenden Ladungsfluss im Stromkreis. Das Auslesen der gespeicherten Information besteht also im Wesentlichen in einem Umschalten der Schicht und der Auswertung der dabei verschobenen elektrischen Ladungen. Nach dem Auslesen kann die Schicht wieder mit der ursprünglichen Information programmiert werden.

Als Materialien für ferroelektrische Halbleiterspeichervorrichtungen kommen in der Regel Perovskite oder geschichtete Perovskite zum Einsatz, und zwar meist PbTiO₃, PbZrₓTi₁₋ₓO₃ (PZT) oder SrBi₂Ta₂O₃ (SBT). Unterhalb der Curie-Temperatur haben diese Materialien eine tetragonale Gitterstruktur mit einer entlang einer der drei kristallografischen Achsen elastisch gedehnten Einheitszelle. Entlang der gedehnten Achse existieren zwei stabile Positionen, die das vierfach positiv geladene Zentralion (Ti, Zr oder Ta) besetzen kann. Da keine dieser beiden Positionen mit dem Massenschwerpunkt der Einheitszelle zusammen fällt, ist die Besetzung beider Positionen mit der Ausbildung eines elektrischen Dipolmoments verbunden.

Zur Realisierung ferroelektrischer Halbleiterspeichervorrichtungen wird die ferroelektrische Schicht in einzelne Speicherzellen aufgeteilt. In jeder Speicherzelle wird die ferroelektrische Schicht mit einer unteren und einer oberen Elektrode kontaktiert, um das elektrische Schreiben, Lesen und Löschen der gespeicherten Information zu ermöglichen. Um ferroelektrische Halbleiterspeichervorrichtungen mit Speicherkapazitäten von mehreren Megabit oder Gigabit zu realisieren, werden die Speicherzellen in zweidimensionalen Feldern angeordnet. Die Anordnung der Speicherzellen in zweidimensionalen Feldern erlaubt die Realisierung einer großen Anzahl (m*n) Zellen mit einer geringen Anzahl von Wort-Leitungen (m) und Bit-Leitungen (n), erfordert für das sichere Auslesen der gespeicherten Information allerdings die Verwendung eines schaltenden Halbleiterbauelements, vorzugsweise eines Feldeffekt-Transistors, in jeder der Zellen.

Die Herstellung konventioneller ferroelektrischer Speicherzellen auf der Grundlage ferroelektrischer Perovskit-Schichten ist aus der Literatur bekannt (siehe z.B. S. R. Gilbert, S. Hunter, D. Ritchey, C. Chi, D. V. Taylor, J. Amano, S. Aggarwal, T. S. Moise, T. Sakoda, S. R. Summerfelt, K. K. Singh, C. Kazemi, D. Carl, and B. Bierman, "Preparation of Pb(Zr,Ti)03 thin films by metalorganic chemical vapor deposition for low voltage ferroetectric memory," Journal of Applied Physics, vol. 93, p. 1713 (2003)).

Ferroelektrische Halbleiterspeichervorrichtungen werden gegenwärtig ausschließlich auf Silizium-Plattformen produziert, d.h. die Herstellung der Halbleiterspeichervorrichtungen erfolgt ausschließlich auf Siliziumsubstraten ("Silizium-Wafer") und ausschließlich unter Verwendung von Transistoren auf der Basis von Silizium als Halbleiter.

Zur Zeit werden Transistor-Konzepte entwickelt, die ohne die Verwendung von Silizium-Wafern auskommen und die die Herstellung von integrierten Schaltungen auf preiswerten Glassubstraten und sogar auf flexiblen Polymerfolien ermöglichen. Grundsätzlich ist es möglich, eine Prozessierung hochwertiger, elektrisch isolierender Polymerschichten auf der Basis von Polyvinylphenol bei Temperaturen von maximal 200 °C und deren Verwendung als Gatedielektrikum für die Herstellung von FeldeffektTransistoren auf der Basis organischer Halbleiter auf beliebigen Substraten (einschließlich Glas, Kunststoff, Papier und flexibler Polymerfolie) auszuführen (siehe z.B.:
H. Klauk, M. Halik, U. Zschieschang, F. Eder, G. Schmid, and C. Dehm, "Pentacene Organic Transistors and Ring Oscillators on Glass and on Flexible Polymeric Substrates," Applied Physics Letters, vol. 82, p. 4175 (2003).

M. Halik, H. Klauk, U. Zschieschang, G. Schmid, W. Radlik, and W. Weber, "Polymer Gate Dielectrics and Conducting Polymer Contacts for High-Performance Organic Thin Film Transistors," Advanced Materials, vol. 14, p. 1717 (2002).

H. Klauk, M. Halik, U. Zschieschang, G. Schmid, W. Radlik, and W. Weber, "High Mobility Polymer Gate Dielectric Pentacene Thin Film Transistors," Journal of Applied Physics, vol. 92, p. 5259 (2002)).

Die zur Herstellung ferroelektrischer Halbleiterspeichervorrichtungen verwendete Abscheidung und Kritallisation ferroelektrischer Schichten auf der Basis der Perovskit-Materialien PbTiO₃, PZT und SBT erfolgt jedoch normalerweise bei relativ hohen Temperaturen (mindestens etwa 600 °C), die weit über der Schmelztemperatur von Polymerfolien (etwa 150 bis 350 °C) und über der Schmelztemperatur von Glas (etwa 550 °C) liegen. Daher ist die Verwendung von PbTiO₃, PZT und SBT auf diesen preiswerten und gegebenenfalls flexiblen Substraten normalerweise nicht möglich.

Der vorliegenden Erfindung liegt somit die Aufgabe zugrunde, eine Halbleiterspeichervorrichtung unter Verwendung mindestens einer ferroelektrischen Schicht auf preiswerten Substraten zu schaffen.

Diese Aufgabe wird erfindungsgemäß durch eine Halbleiterspeichervorrichtung mit den Merkmalen des Anspruchs 1 gelöst.

Erfindungsgemäß ist vorgesehen, eine Halbleiterspeichervorrichtung unter Verwendung mindestens einer ferroelektrischen Schicht bereitszustellen, die mindestens eine ferroelektrische Schicht aus mindestens einem elektrisch nicht leitenden Polymer und in dem Polymer verteilten ferroelektrischen Nanopartikeln aufweist. Durch die Verwendung ferroelektrischer Nanopartikel ist es möglich, eine ferroelektrische Schicht zusammen mit einem Polymer zu realsieren, die die gleichen Eigenschaften wie eine Schicht aufweist, die ganzheitlich aus einem ferroelektrischen Material besteht.

In einer bevorzugten Ausführungsform ist vorgesehen, eine Halbleiterspeichervorrichtung mit mindestens einer ferroelektrischen Schicht unter Verwendung von organischen Halbleitern bereitzustellen. In einer solchen Halbleiterspeichervorrichtung sind vorteilhafterweise schaltende Bauelemente unter Verwendung organischer Halbleiter realisiert.

In einer vorteilhaften Ausführungsform einer solchen Halbleiterspeichervorrichtung weist das Substrat mindestens teilweise Glas, Papier, Kunststoff und / oder Polymerfolien auf oder besteht aus diesen Materialien.

Vorteilhafterweise werden ferroelektrische Nanopartikel, zum Beispiel auf der Basis der Materialien PbTiO3 und PZT, verwendet, die durch ein Sol-Gel-Verfahren oder aus der Gasphase (zum Beispiel durch Kathodenstrahlzerstäubung, Verdampfung oder Laserablation) erzeugt werden (siehe K. S. Seol, S. Tomita, K. Takeuchi, T. Miyagawa, T. Katagiri, and Y. Ohki, "Gas-phase production of monodisperse lead zirconate titanate nanoparticies," Applied Physics Letters, vol. 81, p. 1893 (2002), und B. Jiang, J. L. Peng, L. A. Bursill, and W. L. Zhong, "Size effects on ferroelectricity of ultrafine particles of PbTiO3," Journal of Applied Physics, vol. 87, p. 3462 (2000)). Für die Prozessierung erfindungsgemäßer ferroelektrischer Schichten eignen sich sowohl solche Nanopartikel, die mit einem Sol-Gel-Verfahren erzeugt worden sind, als auch solche Nanopartikel, die mit einem Gasphasenprozess, zum Beispiel durch Kathodenstrahlzerstäubung, Verdampfung oder Laserablation, hergestellt worden sind. Bevorzugt bestehen die Nanopartikel aus Perovskiten, insbesondere PbTiO₃, PbZrₓTi₁₋ₓO₃, und / oder SrBi₂Ta₂O₃.

Die ferroelektrischen Nanopartikel können eine mittlere Größe von etwa 5 nm bis etwa 200 nm haben. Vorzugsweise beträgt ihre Größe etwa 10 bis 50 nm.

Als Polymer zur Herstellung der ferroelektrischen Schicht werden vorteilhafterweise Polymere verwendet, die nicht konjugiert und in organischen Lösungsmitteln leicht löslich sind. In einer bevorzugten Ausführungsform wird Polyvinylphenol als ein Polymer mit den oben genannten Eigenschaften verwendet. Mit Vorteil werden Ethanol und Propylen-GlycolMonomethyl-Ether-Acetat [PGMEA] als Lösungsmittel benutzt.

Um die mindestens eine ferroelektrische Schicht zu erzeugen, sind die ferroelektrischen Nanopartikel bevorzugt in dem Polymer dispergiert. Mit Vorteil sind die ferroelektrischen Nanopartikel in in einem organischen Lösungsmittel gelösten Polymer dispergierbar.

Vorteilhafterweise ist eine so erzeugte Dispersion auf ein Substrat aufschleuderbar.

In einer bevorzugten Ausführungsform sind auf dem Substrat die unteren Elektroden und gegebenenfalls die Transistoren implementiert.

Vorteilhafterweise ist das Lösungsmittel in einem Trocknungsprozess bei einer Temperatur von etwa 100 °C aus der Schicht entfernbar.

Es ist von Vorteil, dass das Polymer thermisch bei einer Temperatur von maximal etwa 200 °C vernetzbar ist. In einer weiteren bevorzugten Ausführungsform ist das Polymer optisch durch Bestrahlung mit kurzwelligem Licht vernetzbar.

Vorteilhafterweise sind auf mindestens einer ferroelektrischen Schicht Elektroden implementiert.

In einer bevorzugten Ausführungsform ist die Halbleiterspeichervorrichtung aus in zweidimensionalen Feldern angeordneten einzelnen Speicherzellen mit den oben beschriebenen Merkmalen realisiert.

Vorteilhafterweise weist dabei jede Speicherzelle jeweils ein schaltendes Halbleiterbauelement, insbesondere einen Feldeffekt-Transistor, aus organischen Halbleitern auf.

In einer bevorzugten Variante ist die Halbleiterspeichervorrichtung programmierbar ausgebildet.

Die Aufgabe wird auch durch ein Verfahren zur Herstellung von Habbleiterspeichervorrichtungen unter Verwendung mindestens einer ferroelektrischen Schicht gelöst. Erfindungsgemäß wird die mindestens eine ferroelektrische Schicht für eine solche Halbleiterspeichervorrichtung durch die Dispersion von ferroelektrischen Nanopartikeln in mindestens einem Polymer hergestellt.

In einer bevorzugten Ausführungsform des Verfahrens erfolgt die Prozessierung der ferroelektrischen Schichten bei Temperaturen unterhalb etwa 200 °C. Gegenüber herkömmlichen Verfahren zur Herstellung ferroelektrischer Halbleiterspeichervorrichtungen bietet dieses den Vorteil, dass die erfindungsgemäßen Halbleiterspeichervorrichtungen auf kostengünstigen und gegebenenfalls flexiblen Substraten hergestellt werden können.

In einer bevorzugten Ausführungsform des Verfahrens wird ein Substrat verwendet, das mindestens teilweise Glas, Papier, Kunststoff und / oder Polymerfolien aufweist oder aus diesen Materialien besteht.

Vorteilhafterweise werden bei dem Verfahren die ferroelelektrischen Nanopartikel mit einem Sol-Gel-Verfahren oder aus der Gasphase, insbesondere durch Kathodenstrahlzerstäubung, Verdampfung oder Laserablation, erzeugt.

In einer bevorzugten Ausführungsform wird das Polymer in einem organischen Lösungsmittel gelöst und die ferroelektrischen Nanopartikel werden in dem gelösten Polymer dispergiert.

Vorteilhafterweise wird die Dispersion dann auf ein Substrat aufgeschleudert. In einer bevorzugten Ausführungsform werden vor dem Aufbringen einer ferroelektrischen Schicht auf dem Substrat Elektroden und gegebenenfalls Transistoren implementiert.

Das Lösungsmittel wird nach dem Aufbringen vorteilhafterweise durch einen Trocknungsprozess bei einer Temperatur von etwa 100°C entfernt.

In einer Variante wird das Polymer thermisch bei einer Temperatur von maximal 200°C oder optisch vernetzt.

Vorteilhafterweise werden auf mindestens einer ferroelektrischen Schicht Elektroden implementiert.

Die Erfindung wird nachfolgend an einem Ausführungsbeispiel näher erläutert. Es zeigt:

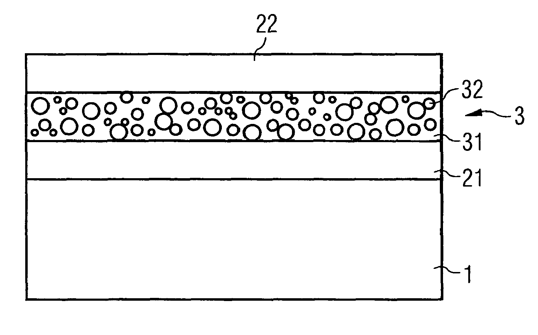

- Fig. 1: eine schematische Schnittansicht einer ferroelektrischen Speicherzelle in einer programmierbaren Halbleiterspeichervorrichtung.

Figur 1 zeigt eine schematische Abbildung einer ferroelektrischen Speicherzelle, die Teil einer hier nicht vollständig dargestellten programmierbaren Halbleiterspeichervorrichtung ist.

Eine programmierbare Halbleiterspeichervorrichtung unter Verwendung mindestens einer ferroelektrischen Schicht ist in der Regel aus einer Vielzahl von Speicherzellen aufgebaut, die in zweidimensionalen Feldern angeordnet sind.

Figur 1 zeigt eine Prinzipskizze einer einzelnen ferroelektrischen Speicherzelle. Auf einem Substrat 1 ist eine erste Elektrode 21 implementiert, die von einer ferroelektrischen Schicht 3 überdeckt ist. Auf der ferroelektrischen Schicht wiederum ist eine zweite Elektrode 22 implementiert. Über eine an die beiden Elektroden 21, 22 angelegte Spannung kann die ferroelektrische Schicht 3 abhängig vom Vorzeichen der Spannung in die eine oder die andere Richtung polarisiert werden. Die so eingestellte Orientierung der elektrischen Dipolmomente bleibt aufgrund der internen Polarisation des ferroelektrischen Materials auch nach Abschalten der elektrischen Spannung erhalten.

Im Gegensatz zur hier gezeigten Ausführungsform ist in einer herkömmlichen ferroelektrischen Speicherzelle die ferroelektrische Schicht 3 ganzheitlich aus einem ferroelektrischen Material aufgebaut. Als Materialien für herkömmliche ferroelektrische Halbleiterspeichervorrichtungen kommen dabei in der Regel Perovskite oder geschichtete Perovskite zum Einsatz, und zwar meist PbTiO₃, PbZrₓTi₁₋ₓO₃ (PZT) oder SrBi₂Ta₂O₃ (SBT). Wegen der zur Herstellung verwendeten Abscheidung und Kritallisation ferroelektrischer Schichten auf der Basis der Perovskit-Materialien PbTiO₃, PZT und SBT notwendigen relativ hohen Temperaturen wird dabei als Material für das Substrat 1 häufig Silizium verwendet.

Figur 1 zeigt eine Ausführungsform einer ferroelektrischen Speicherzelle in einer Ausführungsform der Halbleiterspeichervorrichtung. Die ferroelektrische Schicht 3 besteht aus in einem Polymer 31 dispergierten ferroelektrischen Nanopartikeln 32. Durch die in dem Polymer dispergierten Nanopartikel 32 weist die Schicht 3 ferroelektrische Eigenschaften, ähnlich wie eine ausschließlich aus einem ferroelektrischen Material bestehende Schicht auf. Bevorzugt bestehen die Nanopartikel 32 auch hier aus Perovskiten, insbesondere PbTiO₃, PbZrₓTi₁₋ₓO₃, und / oder SrBi₂Ta₂O₃. Die Funktionsweise einer so realisierten ferroelektrischen Speicherzelle ist genauso wie bei einer oben beschriebenen herkömmlichen ferroelelktrischen Speicherzelle.

Eine Ausführungsform des erfindungsgemäßen Verfahrens zur Herstellung einer programmierbaren Halbleiterspeichervorrichtung mit einer Vielzahl einzelner ferroelektrischer Speicherzellen hat den Vorteil, dass es bei Temperaturen bis maximal 200°C abläuft. Dadurch ist es möglich, als Material für das Substrat 1 Glas, Papier, Kunststoff oder Polymerfolien zu verwenden, also Materialien, die preiswert und gegebenenfalls flexibel sind.

In einer konkreten Ausführungsform des erfindungsgemäßen Verfahrens wird der Strahl eines gepulsten Nd:Yttrium-Aluminium-Garnet- (YAG-) Lasers durch ein Fenster auf die Oberfläche eines in einer Vakuumkammer installierten PZT-Keramik-Zylinders fokussiert, so dass es zur Ablation von PZT-Partikeln von der Oberfläche des Zylinders kommt. Die so erzeugten Nanopartikel werden von einem Sauerstoffstrom erfasst und in einen an die Vakuumkammer angeflanschten Vakuumofen transportiert. Dort werden die Nanopartikel bei einer Temperatur von etwa 900°C und einem Sauerstoffpartialdruck von etwa 400 Pa zu nahezu kugelförmigen Perovskiten kristallisiert, die die gewünschten ferroelektrischen Eigenschaften haben. Die Verweildauer der Nanopartikel im Ofen wird durch den Sauerstofffluss auf etwa 0.05 Sekunden geregelt. Die etwa 20 bis 50 nm großen ferroelektrischen Nanopartikel werden auf einem geeigneten Substrat gesammelt und dann in dem zuvor gelösten Polymer (20 Teile Polyvinylphenol und 1 Teil Poly(Melamin-co-Formaldehyd) in Propylen-Glycol-Monomethyl-Ether-Acetat) dispergiert. Zur Anfertigung der ferroelektrischen Schicht wird die Dispersion aus dem gelösten Polymer und den ferroelektrischen Nanopartikeln auf ein flexibles Polyethylen-Naphthalat-Substrat aufgeschleudert, auf dem zuvor die untere (zum Beispiel metallische) Elektrode abgeschieden und mittels Fotolithographie und nasschemischem Ätzen strukturiert wurde. Die aufgeschleuderte ferroelektrische Schicht wird bei einer Temperatur von 100 °C getrocknet (dabei wird das Lösungsmittel Propylen-Glycol-Monomethyl-Ether-Acetat ausgetrieben) und dann bei einer Temperatur von 200 °C thermisch vernetzt. Abschließend wird auf der ferroelektrischen Schicht die obere (zum Beispiel wiederum metallische) Elektrode erzeugt.

Die Erfindung beschränkt sich in ihrer Ausführung nicht auf die vorstehend angegebenen bevorzugten Ausführungsbeispiele. Vielmehr ist eine Anzahl von Varianten denkbar, die von der erfindungsgemäßen Vorrichtung und dem erfindungsgemäßen Verfahren auch bei grundsätzlich anders gearteten Ausführungen Gebrauch machen.

### Bezugszeichenliste

- 1: Substrat
- 21: Erste Elektrode
- 22: Zweite Elektrode
- 3: Ferroelektrische Schicht
- 31: Polymer
- 32: Ferroelektrische Nanopartikel

## Patentansprüche

1. Halbleiterspeichervorrichtung unter Verwendung mindestens einer ferroelektrischen Schicht,
**dadurch gekennzeichnet, dass**
die mindestens eine ferroelektrische Schicht (3) mindestens ein elektrisch nicht leitendes Polymer (31) mit in dem Polymer (31) verteilten ferroelektrischen Nanopartikeln (32) aufweist.

2. Halbleiterspeichervorrichtung nach Anspruch 1, **dadurch gekennzeichnet, dass** schaltende Bauelemente mit organischen Halbleitern realisiert sind.

3. Halbleiterspeichervorrichtung nach Anspruch 1 oder 2, **gekennzeichnet durch** ein Substrat (1), das mindestens teilweise Glas, Papier, Kunststoff und / oder Polymerfolien aufweist oder aus diesen Materialien besteht.

4. Halbleiterspeichervorrichtung nach mindestens einem der vorhergehenden Ansprüche, **dadurch gekennzeichnet, dass** die ferroelelektrischen Nanopartikel (32) mit einem Sol-Gel-Verfahren erzeugt sind.

5. Halbleiterspeichervorrichtung nach mindestens einem der vorhergehenden Ansprüche, **dadurch gekennzeichnet, dass** die ferroelelektrischen Nanopartikel (32) aus der Gasphase, insbesondere durch Kathodenstrahlzerstäubung, Verdampfung oder Laserablation, erzeugt sind.

6. Halbleiterspeichervorrichtung nach einem der vorhergehenden Ansprüche, **dadurch gekennzeichnet, dass** die ferroelelektrischen Nanopartikel (32) eine Größe zwischen 5 nm und 200 nm aufweisen.

7. Halbleiterspeichervorrichtung nach mindestens einem der vorhergehenden Ansprüche, **dadurch gekennzeichnet, dass** die ferroelektrischen Nanopartikel (32) aus Perovskiten, insbesondere PbTiO₃, PbZrₓTi₁₋ₓO_{3'} und / oder SrBi₂Ta₂O₃ bestehen.

8. Halbleiterspeichervorrichtung nach einem der vorhergehenden Ansprüche, **dadurch gekennzeichnet, dass** das elektrisch nicht leitende Polymer (31) ein konjugiertes, in organischen Lösungsmitteln leicht lösliches Polymer ist.

9. Halbleiterspeichervorrichtung nach Anspruch 8, **dadurch gekennzeichnet, dass** das elektrisch nicht leitende Polymer (31) Polyvinylphenol ist.

10. Halbleiterspeichervorrichtung nach Anspruch 9, **dadurch gekennzeichnet, dass** das Lösungsmittel Ethanol oder Propylen-Glycol-Monomethyl-Ether-Acetat (PGMEA) ist.

11. Halbleiterspeichervorrichtung nach einem der Ansprüche 9 bis 10, **dadurch gekennzeichnet, dass** die ferroelektrischen Nanopartikel (32) in dem gelösten Polymer (3) dispergierbar sind.

12. Halbleiterspeichervorrichtung nach Anspruch 11, **dadurch gekennzeichnet, dass** die Dispersion auf ein Substrat (1) durch Aufschleudern aufbringbar ist.

13. Halbleiterspeichervorrichtung nach Anspruch 12, **dadurch gekennzeichnet, dass** auf dem Substrat (1) Elektroden (21, 22) und gegebenenfalls Transistoren implementiert sind.

14. Halbleiterspeichervorrichtung nach Anspruch 13, **dadurch gekennzeichnet, dass** das Lösungsmittel durch einen Trocknungsprozess bei einer Temperatur von etwa 100°C entfernbar ist.

15. Halbleiterspeichervorrichtung nach Anspruch 14, **dadurch gekennzeichnet, dass** das Polymer (31) thermisch bei einer Temperatur von maximal 200°C oder optisch vernetzbar ist.

16. Halbleiterspeichervorrichtung nach einem der vorhergehenden Ansprüche, **dadurch gekennzeichnet, dass** auf mindestens einer ferroelektrischen Schicht (3) Elektroden implementiert sind.

17. Halbleiterspeichervorrichtung nach einem der vorhergehenden Ansprüche, **dadurch gekennzeichnet, dass** die Halbleiterspeichervorrichtung aus in zweidimensionalen Feldern angeordneten einzelnen Speicherzellen realisiert ist.

18. Halbleiterspeichervorrichtung nach Anspruch 17, **dadurch gekennzeichnet, dass** die einzelnen Speicherzellen jeweils ein schaltendes Halbleiterbauelement, insbesondere einen Feldeffekt-Transistor, aus organischen Halbleitern aufweisen.

19. Halbleiterspeichervorrichtung nach mindestens einem der vorhergehenden Ansprüche, **dadurch gekennzeichnet, dass** diese programmierbar ausgebildet ist.

20. Verfahren zur Herstellung einer Halbleiterspeichervorrichtung unter Verwendung mindestens einer ferroelektrischen Schicht,
**dadurch gekennzeichnet, dass**
die mindestens eine ferroelektrische Schicht (3) durch eine Verteilung, insbesondere Dispersion, von ferroelektrischen Nanopartikeln (32) in mindestens einem Polymer (31) hergestellt wird.

21. Verfahren nach Anspruch 20, **dadurch gekennzeichnet, dass** die Prozessierung der mindestens einen ferroelektrischen Schicht (3) bei Temperaturen unterhalb von 200°C erfolgt.

22. Verfahren nach einem der Ansprüche 20 bis 21, **dadurch gekennzeichnet, dass** Glas, Papier, Kunststoff und / oder Polymerfolien mindestens teilweise als Material für das Substrat (1) verwendet werden.

23. Verfahren nach einem der vorhergehenden Ansprüche 20 bis 22, **dadurch gekennzeichnet, dass** die ferroelelektrischen Nanopartikel (32) mit einem Sol-Gel-Verfahren oder aus der Gasphase, insbesondere durch Kathodenstrahlzerstäubung, Verdampfung oder Laserablation, erzeugt werden.

24. Verfahren nach einem der vorhergehenden Ansprüche 20 bis 23, **dadurch gekennzeichnet, dass** das Polymer (32) in einem organischen Lösungsmittel gelöst wird.

25. Verfahren nach Anspruch 24, **dadurch gekennzeichnet, dass** die ferroelektrischen Nanopartikel (32) in dem gelösten Polymer (32) dispergiert werden.

26. Verfahren nach Anspruch 25, **dadurch gekennzeichnet, dass** die Dispersion auf ein Substrat (1) durch Aufschleudern aufgebracht wird.

27. Verfahren nach Anspruch 26, **dadurch gekennzeichnet, dass** auf dem Substrat (1) vor dem Aufbringen der mindestens einen ferroelektrischen Schicht (3) Elektroden und gegebenenfalls Transistoren implementiert werden.

28. Verfahren nach Anspruch 27, **dadurch gekennzeichnet, dass** das Lösungsmittel durch einen Trocknungsprozess bei einer Temperatur von etwa 100°C entfernt wird.

29. Verfahren nach Anspruch 28, **dadurch gekennzeichnet, dass** das Polymer (31) thermisch bei einer Temperatur von maximal 200°C oder optisch vernetzt wird.

30. Verfahren nach Anspruch 29, **dadurch gekennzeichnet, dass** auf mindestens einer ferroelektrischen Schicht (3) Elektroden implementiert werden.
